# EUROPEAN PATENT APPLICATION

(11) **EP 1 616 991 A1**
(43) Date of publication of application: **18.01.2006**
(21) Application number: 05253384.1
(22) Date of filing: 02.06.2005
(51) Int. Cl.: D06F 39/12

(54) **Domestic appliance having stackable structure**

(30) Priority: 14.07.2004 KR 2004054835
(71) Applicant: SAMSUNG ELECTRONICS CO., LTD., Suwon-si, Gyeonggi-do (KR)
(72) Inventor: Kim, Won Tae, 221-603, ByeokSan Apt., Suwon-Si Gyeonggi-Do (KR)
(74) Representative: Sherrard-Smith, Hugh

(57) **Abstract**

A domestic appliance having a stackable structure for stably vertically stacking with other domestic appliances. The domestic appliances include a first domestic appliance (3) and a second domestic appliance (1) placed on the first domestic appliance (3). A first connecting member (30) is installed on an outer surface of the first domestic appliance (3), for connecting the first domestic appliance (3) to the second domestic appliance (1). A second connecting member (20) sets a position of the first and second domestic appliance (3 and 1) is relative to each other when the first connecting member (30) is connected to the second domestic appliance (1).

## Description

The present invention relates to a domestic appliance such as a washing machine or a drying machine having a stackable structure, and more particularly, to a domestic appliance such as a washing machine or a drying machine having a stackable structure for stable vertical stacking.

In general, for the purpose of effectively using space, a plurality of domestic appliances is installed by being stacked on a stand.

Clothes washing machines and clothes drying machines or other domestic appliances having similar size, shape, and functional relationship are stacked for convenient use.

Registered Korean Patent No. 1985-001800 discloses a clothes washing and drying machine in which a clothes washing machine is combined with a clothes drying machine. The clothes washing and drying machine combination is installed so that the clothes drying machine is installed at the upper side of the stand and the clothes washing machine is installed at the lower side of the stand.

The stand includes a flat shelf where the clothes drying machine is installed, and a horizontal frame for stably supporting the shelf in the vertical direction.

However, the conventional vertical installation structure has a drawback in that it requires a long time to install the stand. Also, the stand is expensive.

Moreover, since the stand is fixed to the wall, the stand must be disassembled when the domestic appliances are moved to another place or installed, independently, so that a great deal of effort and time are required.

According to the present invention there is provided an apparatus and method as set forth in the appended claims. Preferred features of the invention will be apparent from the dependent claims, and the description which follows.

An aspect of the present invention provides a domestic appliance such as a washing machine and drying machine having a stackable structure to be vertically stacked using a connecting device, so that installation time and cost can be reduced.

Another aspect of the present invention provides a domestic appliance having a stackable structure in which the connecting device is constructed to easily connect and disconnect the domestic appliances to and from each other, so that the locations of the domestic appliances can be rapidly changed or the installation of the domestic appliances can be easily achieved by disconnecting the stacking structure.

Additional aspects and/or advantages of the invention will be set forth in part in the description which follows and, in part, will be apparent from the description, or may be learned by practice of the invention.

In one aspect of the present invention there is provided a domestic appliance combination including a first domestic appliance, a second domestic appliance placed on the first domestic appliance, and a connecting member for connecting the first domestic appliance with the second domestic appliance.

The connecting member includes a first connecting member, installed on an outer surface of the first domestic appliance, to connect the first domestic appliance to the second domestic appliance, and a second connecting member to set a connection position of the first domestic appliance.

The first connecting member is installed at a lower side of the first domestic appliance, and the second connecting member is installed at an upper side of the second domestic appliance.

The second connecting member and the first connecting member are constructed to be assembled and disassembled to and from each other.

Moreover, the second connecting member is formed with a locking jaw, and the first connecting member is formed with a locking part locked by the locking jaw.

The locking jaw is formed with a recess having a gradually narrowed width, so that the locking part is easily locked by the locking jaw.

The first domestic appliance may include a clothes washing machine, and the second domestic appliance may include a clothes drying machine.

The first connecting member is installed at a rear side of the first domestic appliance, and the second connecting member is installed at a rear side of the second domestic appliance.

The combination may further include a guide member (10) for guiding the first domestic appliance to the corresponding connecting position when the first domestic appliance is connected with the second domestic appliance.

Moreover, the guide member (10) is detachably installed at a lower side of the second domestic appliance.

These and/or other aspects and advantages of the invention will become apparent and more readily appreciated from the following description of the embodiments, taken in conjunction with the accompanying drawings in which:
Figure 1 is a perspective view illustrating a connected structure of domestic appliances according to the embodiment of the present invention;
Figure 2 is a perspective view illustrating upper and lower connecting members of Figure1;
Figure 3 is a cross-sectional perspective view illustrating a guide member (10) of Figure 1;
Figures 4 to 6 are side views illustrating the process of connecting the domestic appliances according to the embodiment of the present invention.

Reference will now be made in detail to the embodiment of the present invention, an example of which is illustrated in the accompanying drawings, wherein like numerals refer to like elements throughout. A clothes washing machine and a clothes drying machine are described as examples of the domestic appliances, however, other domestic appliances may also be used and still be within the scope of the invention. The embodiments are described below to explain the present invention by referring to the figures.

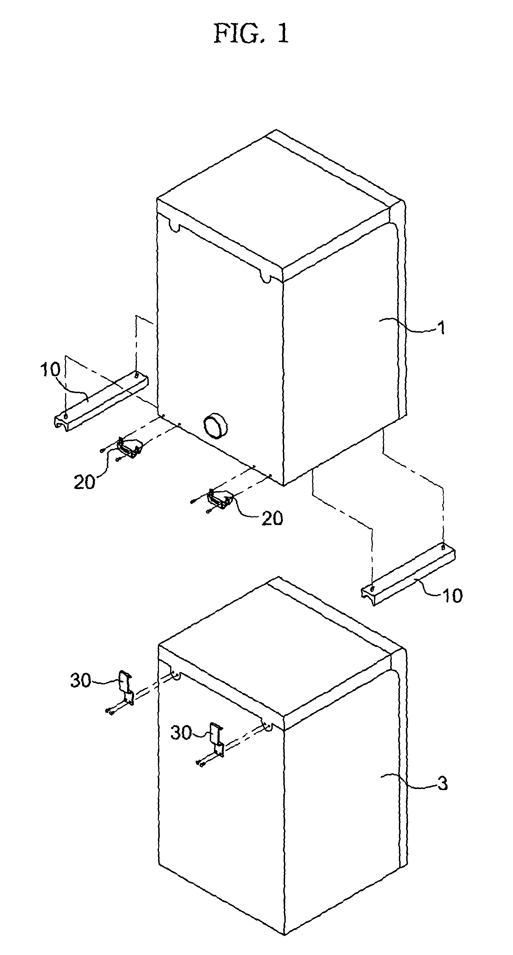

As shown in Figure 1, the stackable domestic appliances according to the embodiment of the present invention include a clothes drying machine 1 installed on a clothes washing machine 3. This provides effective use of space and convenience when washing clothes. Since the clothes washing machine is heavy due to the water supplied thereto, the clothes drying machine 1 is installed on top, while the clothes washing machine 3 is installed underneath.

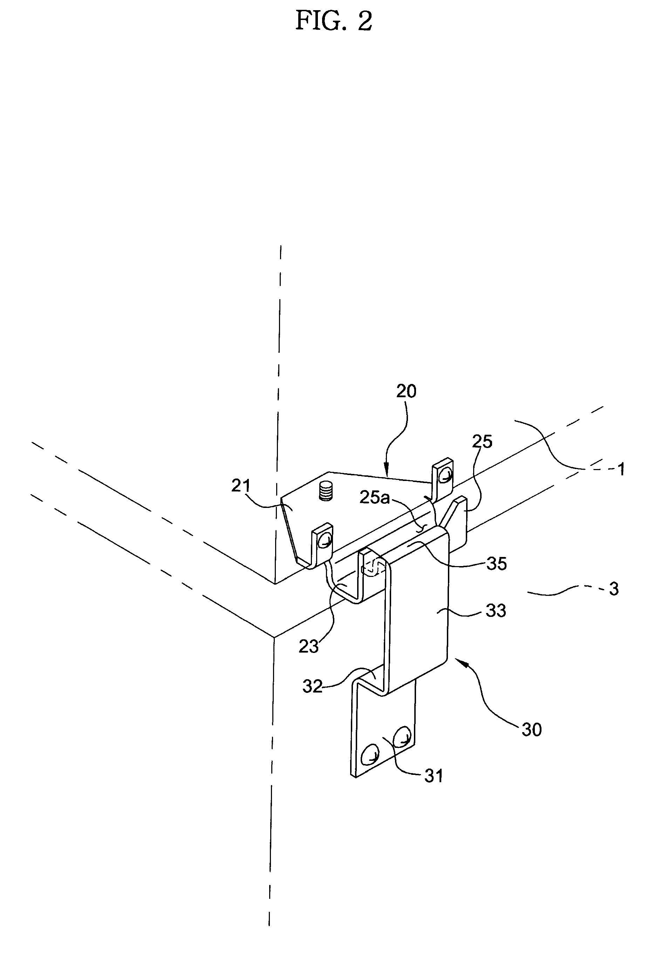

To facilitate installation, the clothes drying machine 1 is installed with an upper connecting member 20 at rear lower sides thereof, and a lower connecting member 30 is installed on rear upper sides of the clothes washing machine 3. The upper and lower connecting members 20 and 30 are fixed to the clothes drying machine 1 and the clothes washing machine 3, respectively, and are constructed to be easily assembled and disassembled. A detailed structure of the upper and lower connecting members 20 and 30 will be described later by reference to Figure 2.

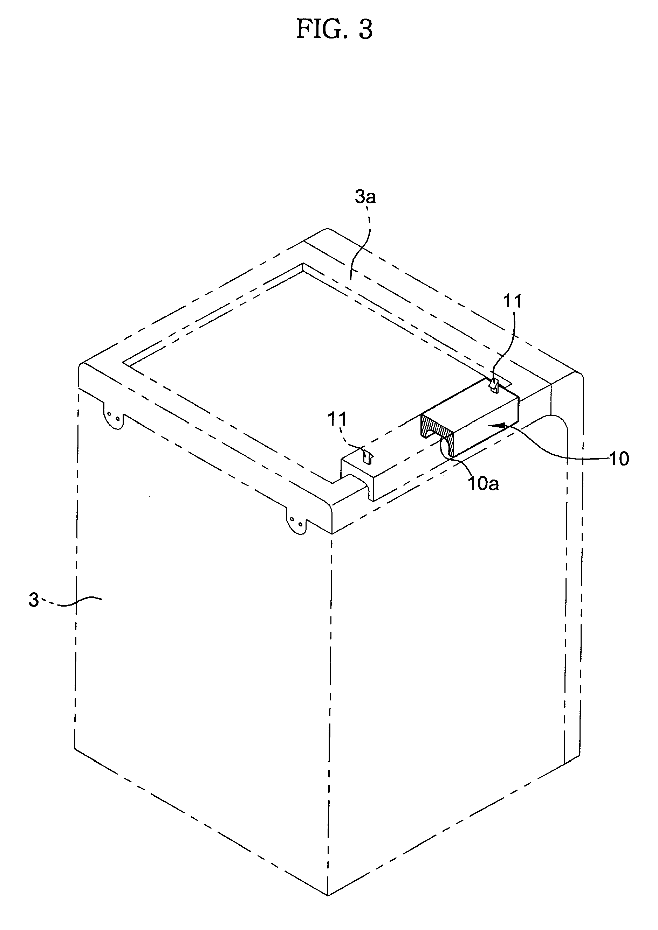

The clothes drying machine 1 is installed with a guide member 10 at the lower sides thereof. The guide member 10 guides the clothes drying machine 1 to move to a predetermined position relative to the clothes drying machine 1 for connection therebetween during installation. The guide member 10 fixes the clothes drying machine 1 to the clothes washing machine 3 when the clothes drying machine 1 has been installed on the clothes washing machine 3. A detailed structure of the guide member 10 will be described later by reference to Figure 3.

Figure 2 is a perspective view illustrating the assembly of the upper connecting member 20 and the lower connecting member 30. As shown in Figure 2, the upper connecting member 20 is formed with a locking jaw 25, and the lower connecting member 30 is formed with a locking part 35. The locking part 35 is locked by the locking jaw 25, so that the upper connecting member 20 is connected to the lower connecting member 30.

As shown in Figure 2, the upper connecting member 20, installed at the rear lower sides of the clothes drying machine 1, has a clothes drying machine fixing part 21 to be fixed to the clothes drying machine 1. The clothes drying machine fixing part 21 is fixed to the clothes drying machine 1 by fixing members such as screws, so that the clothes drying machine fixing part 21 is closely fixed to the rear side and the lower side of the clothes drying machine 1. The clothes drying machine fixing part 21 is formed with a supporting plane 23 horizontally extending from the rear side thereof, and is formed with the locking jaw 25 vertically extending from the upper side of the supporting plane 23. The locking jaw 25 is formed with a guide recess 25a at the upper side thereof.

Meanwhile, the lower connecting member 30, connected to the rear upper side of the clothes washing machine 3, has a clothes washing machine fixing part 31 to be fixed to the clothes washing machine 3. The clothes washing machine fixing part 31 is fixed to the clothes washing machine 3 by fixing members such as screws, so that the clothes washing machine fixing part 31 is closely fixed to the rear side of the clothes washing machine 3. Thus, the lower corner of the clothes drying machine 1 is reinforced, to add rigidity to the lower corner. The lower connecting member 30 further has a horizontal part 32 horizontally extending from the upper end of the clothes washing machine fixing part 31 to the rear side of the clothes washing machine 3, and a vertical part 33 vertically extending from the horizontal part 32 upward. The vertical part 33 has the hook-shaped locking part 35 formed at the upper end thereof and locked by the locking jaw 25 of the upper connecting member 20. The end of the locking part 35 is horizontally extended to be placed on the supporting plane 23.

Since the locking jaw 25 is formed with the inclined guide recess 25a having a gradually narrowed width, the clothes drying machine 1 and the clothes washing machine 3 are automatically arranged by locking the locking part 35 to the locking jaw 25 even when the clothes drying machine 1 and the clothes washing machine 3 are not properly oriented.

Figure 3 is a perspective cross sectional view illustrating the guide member 10. The rod-shaped guide member 10 is formed with hooks 11 at sides thereof, so that the guide member 10 can be attachably and detachably installed to the lower side of the clothes drying machine 1. The guide member 10 is formed with a recess 10a at the lower side thereof in the longitudinal direction, so that a rim 3a protruded from the upper surface of the clothes washing machine 3 is inserted into the recess 10a.

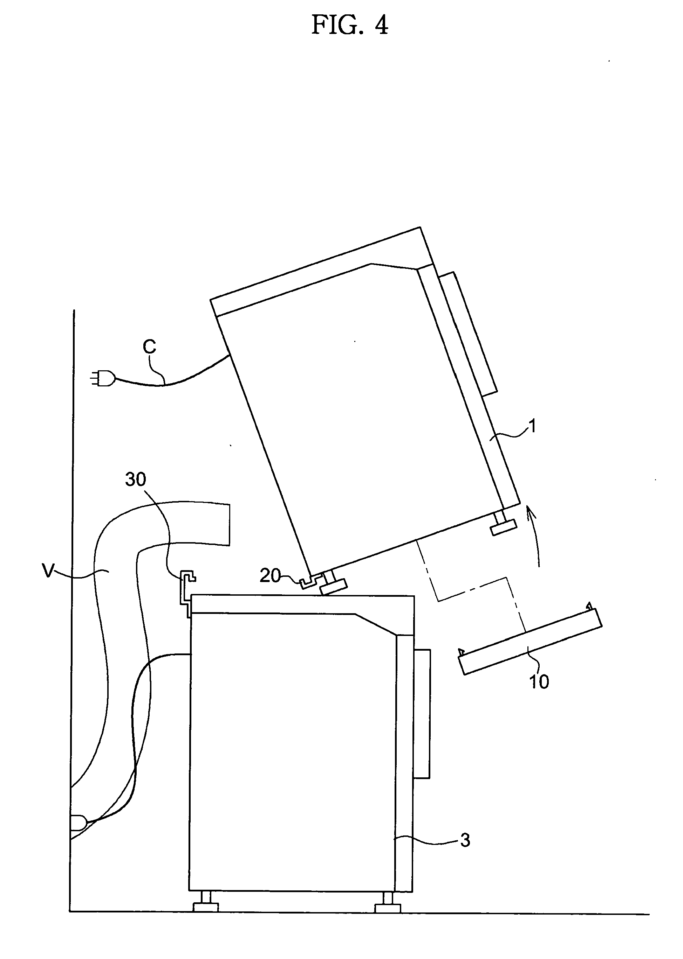

The vertical stacking of the domestic appliances according to the embodiment of the present invention will be described by reference to Figures 4 to 6.

First, as shown in Figure 4, the upper connecting member 20 is installed on the clothes drying machine 1 and the lower connecting member 30 is installed on the clothes washing machine 3, then the clothes drying machine 1 is placed on the clothes washing machine 3. When the rear lower side of the clothes drying machine 1 is placed on the clothes washing machine 3, the guide member 10 is installed to the lower side of the clothes drying machine 1.

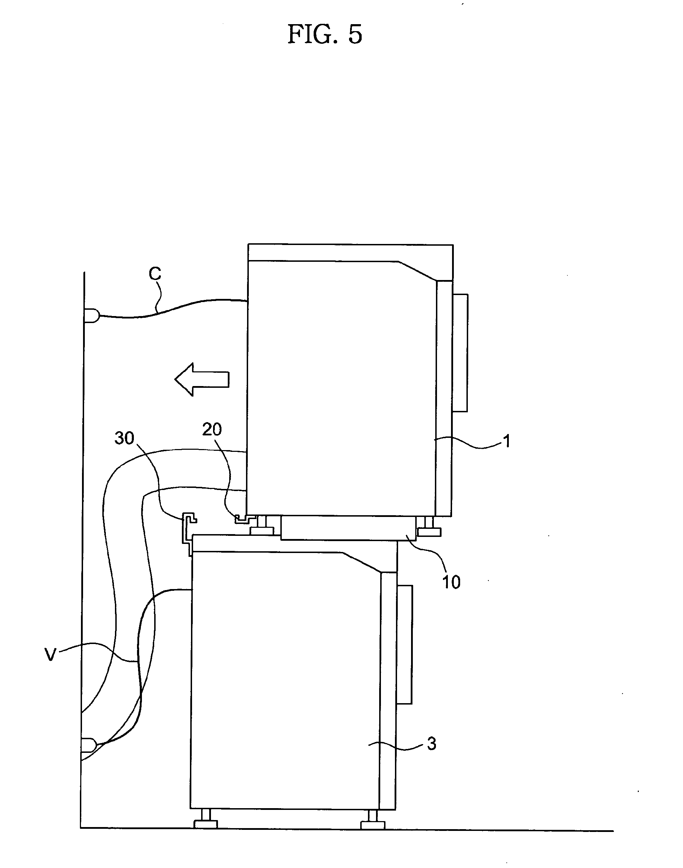

Next, as shown in Figure 5, the front side of the clothes drying machine 1 is lowered, so as to install the electric wire "c" and an air blowing conduit "v" to the clothes drying machine 1 in the state that the rim 3a of the clothes washing machine 3 comes in contact with the recess 10a of the guide member 10, and then the clothes drying machine 1 is moved rearward.

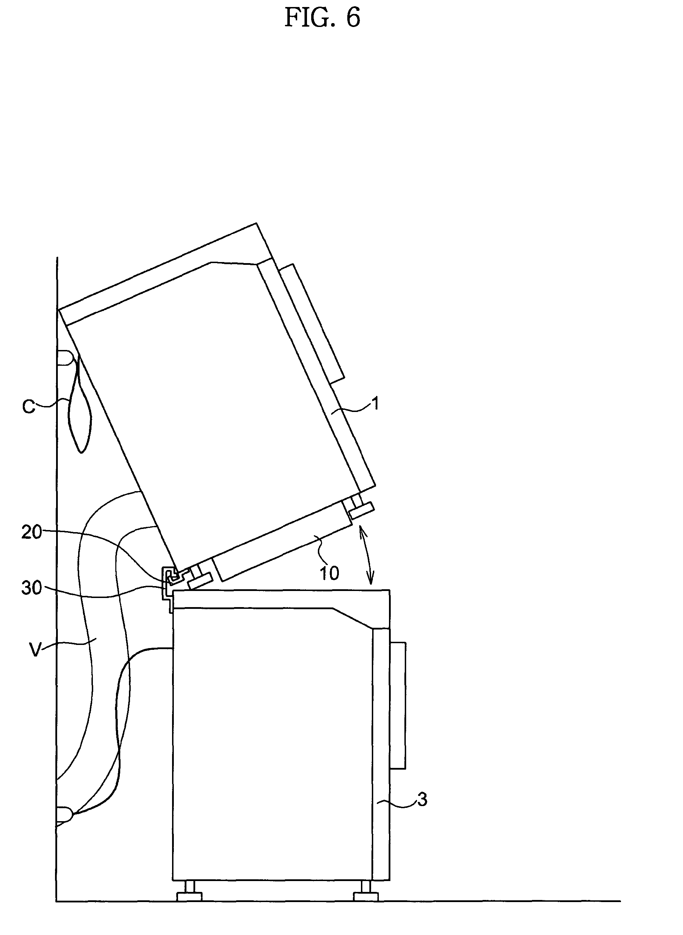

When the clothes drying machine 1 is sufficiently moved rearward so that the upper connecting member 20 approaches the lower connecting member 30, as shown in Figure 6, the front side of the clothes drying machine 1 is raised so that the locking part 35 is placed on the locking jaw 25 of the upper connecting member 20. Next, when the front side of the clothes drying machine 1 is lowered, the locking part 35 of the lower connecting member 30 is locked by the locking jaw 25 of the upper connecting member 20 and the guide member 10 comes in contact with the upper surface of the clothes washing machine 3, so that the clothes drying machine 1 is firmly fixed on the clothes washing machine 3.

As described above, according to a domestic appliance according to the embodiment of the present invention, time and expense required for installation can be reduced due to the connection of the domestic appliances by the connecting members.

Moreover, since the connecting members are constructed to allow easy assembly and disassembly, the locations of the domestic appliances can be rapidly changed or the independent installation of the domestic appliances can be easily achieved by disconnecting the stacking structure.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A domestic appliance combination comprising:
a first domestic appliance (3);
a second domestic appliance (1) on the first domestic appliance (3);
a first connecting member (30), installed on an outer surface of the first domestic appliance (3), to connect the first domestic appliance (3) to the second domestic appliance (1) ; and
a second connecting member (20) to set a position of the first and second domestic appliances (3, 1) relative to each other when the first connecting member (30) is connected to the second domestic appliance (1).

2. The domestic appliance combination as set forth in claim 1, wherein the first connecting member (30) and the second connecting member (20) are selectively connected.

3. The domestic appliance combination as set forth in claim 1 or 2, wherein the first connecting member (30) is installed at an upper side of the first domestic appliance (3), and the second connecting member (20) is installed at a lower side of the second domestic appliance (1).

4. The domestic appliance combination as set forth in claim 1, 2 or 3, wherein the second connecting member (20) comprises a locking jaw (25), and the first connecting member (30) comprises a locking part (35) locked by the locking jaw (25).

5. The domestic appliance combination as set forth in claim 4, wherein the locking jaw (25) comprises a recess (25a) having a gradually narrowed width to receive the locking part (35).

6. The domestic appliance as set forth in preceding claim, wherein the first domestic appliance (3) comprises a clothes washing machine, and the second domestic appliance (1) comprises a clothes drying machine.

7. The domestic appliance combination as set forth in any preceding claim, wherein the first connecting member (30) is installed at a rear side of the first domestic appliance (3), and the second connecting member (20) is installed at a rear side of the second domestic appliance (1).

8. The domestic appliance combination as set forth in any preceding claim, further comprising a guide member (10) to guide the first domestic appliance (3) to the corresponding connecting position with the second domestic appliance (1) when the first domestic appliance (3) is connected to the second domestic appliance (1).

9. The domestic appliance combination as set forth in claim 8, wherein the guide member (10) is detachably installed at a lower side of the second domestic appliance (1).

10. The domestic appliance combination as set forth in claim 4 or any of claims 5 to 9 when dependent thereon, wherein the second connecting member (20) further comprises a second fixing part (21) fixed to the second domestic appliance (1), the second fixing part (1) comprising a substantially horizontal supporting plane, the locking jaw (25) extending from an upper side of the supporting plane.

11. The domestic appliance combination as set forth in claim 4 or any of the claims 5 to 10 when dependent thereon, wherein the first connecting member (30) comprises:
a fixing part (31) fixed to an upper portion of a side of the first domestic appliance;
a horizontal part (32) extending substantially horizontally from the fixing part (21);
a vertical part (33) extending substantially vertically from the horizontal part (32), comprising the locking part (35).

12. The domestic appliance combination as set forth in claim 11, wherein the locking part (35) is hook-shaped.

13. The domestic appliance combination as set forth in claim 8 or any of claims 9 to 12 when dependent thereon, wherein the guide member (10) comprises hooks (11) at sides thereof to be attached and detached to and from the second domestic appliance (1).

14. The domestic appliance combination as set forth in claim 8 or any of claims 9 to 13 when dependent thereon, wherein the guide member (10) comprises a recess (10a) and the first domestic appliance (3) comprises a rim (3a) to receive the recess (10a).

15. The domestic appliance combination as set forth in claim 4 or any of claims 5 to 14 when dependent thereon, wherein the locking part (35) is placed in the locking jaw (25) by raising a front side of the second domestic appliance (1), and the locking part (35) is locked in the locking jaw (25) by lowering the raised front side of the second domestic appliance (1).

16. A domestic appliance (1,3) to be stacked on or below a corresponding domestic appliance (3,1) having a corresponding connecting member (30, 20), the domestic appliance comprising:
a connecting member (20, 30) to be selectively attached to/detached from the corresponding connecting member (30, 20).

17. The domestic appliance as set forth in claim 16, wherein the connecting member is a locking jaw (25).

18. The domestic appliance as set forth in claim 16, wherein the connecting member has a hook shape (35).
